# EUROPÄISCHE PATENTSCHRIFT

(11) **EP 2 867 622 B1**
(45) Veröffentlichungstag und Bekanntmachung des Hinweises auf die Patenterteilung: **09.08.2017**
(21) Anmeldenummer: 13731034.8
(22) Anmeldetag: 17.06.2013
(51) Int. Cl.: G01D 3/08, G01P 3/481

(54) **ANORDNUNG ZUR BESTIMMUNG EINER UMDREHUNGSANZAHL EINER DREHBAR GELAGERTEN WELLE UND VERFAHREN ZUR BESTIMMUNG EINER UMDREHUNGSANZAHL EINER DREHBAR GELAGERTEN WELLE**
ARRANGEMENT FOR DETERMINING A NUMBER OF ROTATIONS OF A ROTATABLY MOUNTED SHAFT, AND METHOD FOR DETERMINING A NUMBER OF ROTATIONS OF A ROTATABLY MOUNTED SHAFT
DISPOSITION POUR DÉTERMINER UN NOMBRE DE RÉVOLUTIONS D'UN ARBRE LOGÉ DE MANIÈRE À POUVOIR TOURNER ET PROCÉDÉ POUR LA DÉTERMINATION D'UN NOMBRE DE RÉVOLUTIONS D'UN ARBRE LOGÉ DE MANIÈRE POUVOIR TOURNER

(30) Priorität: 28.06.2012 DE 102012012874
(43) Veröffentlichungstag der Anmeldung: 06.05.2015
(73) Patentinhaber: Sew-Eurodrive GmbH & Co. KG, 76646 Bruchsal (DE)
(72) Erfinder: SIMON, Olaf, 76646 Bruchsal (DE); MEYROWITZ, Gunnar, 26123 Oldenburg (DE)
(86) Internationale Anmeldenummer: PCT/EP2013/001786
(87) Internationale Veröffentlichungsnummer: WO 2014/000869

(56) Entgegenhaltungen:
- EP-A1- 1 550 845
- EP-A2- 2 221 587
- DE-A1-102007 062 780

## Beschreibung

Die Erfindung betrifft eine Anordnung zur Bestimmung einer Umdrehungsanzahl einer drehbar gelagerten Welle und ein Verfahren zur Bestimmung einer Umdrehungsanzahl einer drehbar gelagerten Welle.

Es ist allgemein bekannt, dass mit einem Winkelsensor die Winkelstellung der Welle bestimmbar ist. Dabei sind pro Umdrehung fein aufgelöste Winkelwerte bestimmbar, wie beispielsweise mit einer Auflösung von 1°. Die Umdrehungsanzahl ist die Anzahl der ganz ausgeführten Umdrehungen der Welle. Die Absolutwinkelposition ist bestimmt durch den Wert der Umdrehungsanzahl und der Feinwinkelposition.

Als Mikrogenerator ist entweder ein Wieganddraht, also Impulsdraht bekannt oder alternativ ein magnetisch mechanisch vorspannbares und danach magnetisch mechanisch auslösbares System, das bei Auslösen des Systems Spannung induziert in eine Spule. Insbesondere bei Systemen mit Wieganddraht wird das Auslösen dabei durch einen anderen magnetischen Pol bewirkt als das Vorspannen. Aus der EP 2 221 587 A2 ist ein absolut magnetische Positionsgeber bekannt, wobei die Energieversorgung teilweise aus den Spannungspulses eines WiegandDraht und teilweise aus einer externen Versorgungsquelle geliefert wird. Der Erfindung liegt daher die Aufgabe zugrunde, eine Anordnung zur Bestimmung einer Umdrehungsanzahl einer drehbar gelagerten Welle weiterzubilden, wobei die Fehlerrate verringert werden soll.

Erfindungsgemäß wird die Aufgabe bei der Anordnung zur Bestimmung einer Umdrehungsanzahl einer drehbar gelagerten Welle nach den in Anspruch 1 und bei dem Verfahren nach den in Anspruch 7 angegebenen Merkmalen gelöst.

Wichtige Merkmale der Erfindung bei der Anordnung zur Bestimmung einer Umdrehungsanzahl einer drehbar gelagerten Welle sind, dass ein Dauermagnet mit der Welle drehfest verbunden ist,
wobei die von einem mit dem Dauermagnet in Wirkverbindung angeordneten Mikrogenerator erzeugte Signalspannung einem Energiepuffer, insbesondere über einen Gleichrichter einem Kondensator, zugeführt wird,
wobei ein Speicher zur Speicherung der Umdrehungszahl aus dem Energiepuffer versorgt ist,
insbesondere wobei die Signalspannung des Mikrogenerators einer aus dem Energiepuffer versorgten Zähllogik zugeführt wird, die mit dem Speicher verbunden ist zum Auslesen des jeweils alten Umdrehungsanzahlwertes und zur Abspeicherung des jeweils neu bestimmten Umdrehungsanzahlwertes,
insbesondere wobei der Speicher langzeitstabil ist und/oder in FRAM-Technik ausgeführt ist,
insbesondere wobei der Dauermagnet im empfindlichen Bereich des Mikrogenerators angeordnet ist,
wobei ein Winkelsensor zur Bestimmung der Drehstellung, insbesondere des Drehwinkels, der Welle mittels einer Signalleitung mit einem Rechner, beispielsweise Mikrocontroller oder Mikroprozessor, verbunden ist,
wobei vom Rechner die am Energiepuffer anliegende Spannung ausgewertet wird,
insbesondere wobei der Rechner ein Mittel zur Auswertung der am Energiepuffer anliegenden Spannung aufweist und/oder mit einem solchen Mittel verbunden ist, insbesondere über eine Datenaustauschverbindung.

Von Vorteil ist dabei, dass zwar einerseits eine energieautarke Bestimmung der Umdrehungsanzahl ausführbar ist andererseits aber eine Kontrolle oder Überwachung des Umdrehungsanzahlwertes ausführbar ist, indem ein Rechner, der fremdversorgt ist, zur Überwachung und Auswertung der Signale des Mikrogenerators, insbesondere also Wieganddrahtes oder Impulsdrahts, verwendbar ist. Auf diese Weise wird also überwacht, ob ein vom Mikrogenerator erzeugter Signalpuls ein Kümmerling ist, weil der Drehsinn der Welle im Winkelbereich des Vorspannens und/oder Auslösens verändert wurde, oder ob ein Defekt aufgetreten ist. Insbesondere ist dabei detektierbar, ob der Signalpuls eine der Auslegung entsprechende ausreichende Höhe bzw. einen ausreichenden Energieinhalt aufweist. Ist dies nicht der Fall, liegt entweder der erwähnte als Kümmerling ausgeprägte Signalpuls vor oder es ist ein Defekt oder eine Dejustage des Gebers aufgetreten. Bei einem solchen Defekt ist eine Warnmeldung auslösbar, sogar schon bevor eine Fehlfunktion auftritt.

Bei einer vorteilhaften Ausgestaltung ist der Mikrogenerator als Wieganddraht ausgeführt oder umfasst einen Wieganddraht. Von Vorteil ist dabei, dass keine verschleißbehafteten mechanischen Bauteile notwendig sind.

Im Falle des Einsatzes eines Wieganddrahtes als Mikrogenerator in Form eines Wiegandsensors, können bei Drehrichtungswechseln auch im störungsfreien Betrieb Signalimpulse mit geringer Signalamplitude auftreten. Dies ist der Fall, wenn der Wieganddraht nach erfolgtem Impuls nicht oder nicht vollständig vorgespannt wird und aufgrund des Drehrichtungswechsels trotzdem eine Auslösung in die entgegengesetzte magnetische Feldrichtung erfolgt. Derartige Signalimpulse werden als Kümmerlinge bezeichnet. Damit die Signalüberwachungseinrichtung derartige Impulse nicht als Störung interpretiert, dürfen nur Impulse ausgewertet werden, bei denen vorher eine vollständige Vorspannung festgestellt worden ist. Die Feststellung der vollständigen Vorspannung ist dadurch ausführbar, dass ein bestimmter Winkelwert des die Drehstellung der Welle fein auflösenden Winkelsensors überschritten worden ist, insbesondere die Parallelität des den Wiegandsensor auslösenden magnetischen Feldes mit dem Wiegandsensor.

Bei einer vorteilhaften Ausgestaltung ist der Mikrogenerator als Impulsdraht ausgeführt. Von Vorteil ist dabei, dass ein kostengünstig herstellbares Bauelement einsetzbar ist, das keinen Verschleiß aufweist.

Bei einer vorteilhaften Ausgestaltung ist zwischen Rechner und Speicher eine Signalleitung, insbesondere zum Datenaustausch, angeordnet. Von Vorteil ist dabei, dass der im Speicher gespeicherte Wert vom Rechner auslesbar ist und dort auswertbar ist. Insbesondere ist der bei Beginn des Betriebs des Rechners der Anfangswert, also Offsetwert, der Umdrehungsanzahl aus dem Speicher auslesbar und als Anfangswert im Rechner übernehmbar. Des Weiteren ist im Betrieb ein stets wiederholter Vergleich ausführbar zwischen dem im Rechner bestimmten Umdrehungsanzahlwert und dem im Speicher jeweils gespeicherten Umdrehungsanzahlwert.

Bei einer vorteilhaften Ausgestaltung sind der Winkelsensor und der Rechner von einer Spannungsquelle versorgt, insbesondere aus welcher die Zähllogik und der Energiepuffer nicht versorgt sind. Von Vorteil ist dabei, dass für den Rechner eine Fremdversorgung ausführbar ist.

Bei einer vorteilhaften Ausgestaltung weist der Winkelsensor einen Hallsensor auf, der in Wirkverbindung mit dem Dauermagnet ist, oder der Winkelsensor ein mit der Welle verbundener Resolver oder ein Inkrementalgeber ist. Von Vorteil ist dabei, dass ein kostengünstiges hoch auflösendes System einsetzbar ist.

Wichtige Merkmale bei dem Verfahren zur Bestimmung einer Umdrehungsanzahl einer drehbar gelagerten Welle sind, dass ein Dauermagnet mit der Welle drehfest verbunden ist,
wobei die von einem mit dem Dauermagnet in Wirkverbindung angeordneten Mikrogenerator erzeugte Signalspannung einem Energiepuffer, insbesondere über einen Gleichrichter einem Kondensator, zugeführt wird,
wobei ein Speicher, in welchem die jeweils aktuell bestimmten Umdrehungsanzahlwerte gespeichert werden, aus dem Energiepuffer versorgt wird,
insbesondere wobei die Signalspannung des Mikrogenerators einer aus dem Energiepuffer versorgten Zähllogik zugeführt wird, die mit dem Speicher verbunden ist zum Auslesen des jeweils alten Umdrehungsanzahlwertes und zur Abspeicherung des jeweils neu bestimmten Umdrehungsanzahlwertes,
insbesondere wobei der Speicher langzeitstabil ist und/oder in FRAM-Technik ausgeführt ist,
insbesondere wobei der Dauermagnet im empfindlichen Bereich des Mikrogenerators angeordnet ist,
wobei mit einem Winkelsensor der Drehwinkel der Welle bestimmt wird und einem Rechner zugeführt wird,
**wobei** vom Rechner die am Energiepuffer anliegende Spannung ausgewertet wird, wobei der vom Winkelsensor detektierte Drehwinkel berücksichtigt wird.

Von Vorteil ist dabei, dass der im energieautark betreibbaren Teil der Schaltungsanordnung der Umdrehungsanzahlwert speicherbar ist und dieser Wert vom fremdversorgten Rechner überwachbar und kontrollierbar ist - zumindest in derjenigen Zeit, in der eine fremdversorgte Energie zur Verfügung steht. Somit sind Defekte in der Anordnung erkennbar.

Bei einer vorteilhaften Ausgestaltung wird aus dem am Energiepuffer auftretenden Spannungsverlauf ein Wert zumindest einer Kenngröße, insbesondere Zustandsgröße, des Spannungsverlaufs ermittelt und ein Fehlersignal oder eine Fehlermeldung wird ausgelöst bei Unter- oder Über-schreiten eines kritischen, also definierten, insbesondere vorgegebenen, Grenzwertes.

Bei einer vorteilhaften Ausgestaltung wird als Kenngröße der Maximalwert des Spannungsimpulses verwendet.

Bei einer vorteilhaften Ausgestaltung werden nacheinander mehrere Spannungsimpulse vermessen und deren Kennwerte einer statistischen Auswertung unterzogen. Erreichen die statistischen Kennwerte definierte Grenzwerte nicht oder überschreiten diese, so wird ein Fehlersignal oder eine Fehlermeldung generiert.

Bei einer vorteilhaften Ausgestaltung werden als statistische Kennwerte der Mittelwert und/oder die Standardabweichung und/oder der Mittelwert des Betrages der Differenz vom Mittelwert, also die mittlere Betragsabweichung, verwendet.

Auf diese Weise ist der Mittelwert aus den zeitlich vorher ermittelten, entsprechenden Werten der Kenngröße bestimmt,
insbesondere wobei das Maß von einer statistischen Größe abhängt, insbesondere von einer Standardabweichung, von einem trivialen oder höheren Moment einer Verteilungsfunktion oder dergleichen,
insbesondere wobei das Maß dem mit einem Faktor multiplizierten statistischen Moment entspricht, insbesondere wobei das Moment die Standardabweichung ist. Von Vorteil ist dabei, dass durch den Vergleich mit einer statistischen Größe, wie Mittelwert, bestimmbar ist, ob der aktuell ausgewertete Puls ein unzulässig hohe Abweichung aufweist und somit von einem Defekt verursacht ist oder ein Kümmerling ist.

Unter Zustandsgröße wird in dieser Schrift eine makroskopische physikalische Größe verstanden, die den Zustand des erfindungsgemäßen Systems kennzeichnet. Beispielsweise zählt hierzu die Form des vom Mikrogenerator erzeugten Signalpulses oder ein oder mehrere Parameter dieses Pulses, wie beispielsweise Spannungs-Zeit-Fläche, Maximalwert, maximaler Wert der zeitlichen Ableitung de3s Spannungsverlaufes oder dergleichen.

Bei einer vorteilhaften Ausgestaltung wird aus dem am Energiepuffer auftretenden pulsartigen Spannungsverlauf ein Wert einer Kenngröße, insbesondere Zustandsgröße, des pulsartigen Spannungsverlaufs ermittelt und
- entweder wird
   der aktuelle Spannungspuls nicht zum Bestimmen der Umdrehungsanzahl verwendet, wenn in einem zum Spannungspuls zugehörigen Winkelabschnitt und/oder Zeitabschnitt eine Drehsinnänderung der Welle vom Winkelsensor detektiert wird und wenn ein kritisches, insbesondere vorgegebenes, Maß an Abweichung des Wertes von einem Mittelwert, überschritten wird,
- oder ansonsten wird
   ein Fehlersignal ausgelöst, wenn das kritische, insbesondere vorgegebene, Maß an Abweichung des Wertes von einem Mittelwert überschritten wird,
wobei der Mittelwert aus den zeitlich vorher ermittelten, entsprechenden Werten der Kenngröße bestimmt ist,
insbesondere wobei das Maß von einer statistischen Größe abhängt, insbesondere von einer Standardabweichung, von einem höheren Moment einer Verteilungsfunktion oder dergleichen,
insbesondere wobei das Maß dem mit einem Faktor multiplizierten statistischen Moment entspricht, insbesondere wobei das Moment die Standardabweichung ist. Von Vorteil ist dabei, dass ein Defekt der Anordnung feststellbar ist und somit eine erhöhte Sicherheit erreichbar ist.

Bei einer vorteilhaften Ausgestaltung ist die Kenngröße eine Amplitude, also Maximalwert, des Spannungssignals oder der Spannungswert zu einem festgelegten Zeitpunkt nach Beginn des Spannungsimpulses
und/oder die Kenngröße ist eine gemittelte oder maximale Spannungsänderungsgeschwindigkeit,
und/oder die Kenngröße ist eine gemittelte oder maximale Spannungs-Zeit-Fläche ist. Von Vorteil ist dabei, dass nicht nur die Amplitude des jeweils aktuellen Pulses sondern auch der Verlauf des Pulssignals auswertbar ist.

Bei einer vorteilhaften Ausgestaltung wird zum jeweiligen Ermitteln des Wertes der Kenngröße des pulsartigen Spannungsverlaufs ein durch einen Trigger-Puls gekennzeichneter Zeitabschnitt, insbesondere also ungefährer Zeitpunkt, des pulsartigen Spannungsverlaufs ausgewertet, insbesondere vom Rechner. Von Vorteil ist dabei, dass der Trigger-Puls und die bei seiner Auslösung auftretende Spannung des jeweils aktuellen Pulses auswertbar ist und somit auch der Energiegehalt des Pulses überwachbar ist.

Bei einer vorteilhaften Ausgestaltung werden die in digitale Werte gewandelten Abtastwerte des pulsförmigen Spannungsverlaufs einem zyklisch betriebenen Speicher zugeführt und die Auswertung des pulsförmigen Spannungsverlaufs erfolgt durch Auswertung der im zyklischen Speicher abgespeicherten Werte, insbesondere nach jeweiligem Eintreffen des Trigger-Pulses. Von Vorteil ist dabei, dass eine ständige analog-Digital-Wandlung ausführbar ist und erst nach Eingang des Trigger-Pulses ein Auswerten auszuführbar ist. Somit ist auch der schon vor Eingang des Trigger-Pulses auftretende Spannungsanstieg auswertbar und somit eine verbesserte Überwachung ausführbar. Die Aufnahmekapazität des zyklischen Speichers, also die Anzahl der von dem zyklischen Speicher speicherbaren Werte, ist derart vorsehbar, dass der relevante Zeitabschnitt des vom Wieganddraht generierten Pulses überwachbar ist. Da die zeitliche Pulslänge unabhängig ist von der Drehgeschwindigkeit der Welle und somit immer gleich ist die Aufnahmekapazität auf die Pulslänge abstimmbar.

Bei einer vorteilhaften Ausgestaltung wird der Trigger-Puls durch das Überschreiten eines kritischen Wertes durch den pulsförmigen Spannungsverlauf erzeugt. Von Vorteil ist dabei, dass dieser Wert mit einfachen Mitteln erzeugbar und ebenfalls auswertbar ist und somit auch der Energiegehalt des vom Mikrogenerator erzeugten Pulses überwachbar ist.

Bei einer anderen vorteilhaften Ausgestaltung wird als Trigger-Puls das Signal des Mikrogenerators verwendet, welches den Zählvorgang im nicht-flüchtigen Speicher des Umdrehungszählers initiiert. Da dieses Signal für die Grundfunktion des Umdrehungszählers bereits vorhanden ist, müssen keine zusätzlichen Signale generiert werden, die der Überwachung des Pulssignals dienen.

Bei einer vorteilhaften Ausgestaltung wird zu Beginn der Inbetriebnahme oder zu Beginn des elektrischen Versorgens des Rechners die aktuelle Umdrehungsanzahl aus dem Speicher zur Speicherung der Umdrehungszahl ausgelesen und vom Rechner als anfänglicher Wert für Umdrehungsanzahl verwendet,
wobei aus dem mittels des Winkelsensors bestimmten Verlaufs der Winkelstellung die nach dem Beginn durchlaufene Umdrehungsanzahl bestimmt wird und die Summe aus dieser Umdrehungsanzahl und dem anfänglichen Wert als jeweils aktuelle Umdrehungsanzahl im Rechner gespeichert wird. Von Vorteil ist dabei, dass eine Überwachung der Umdrehungsanzahl ausführbar ist und somit die Sicherheit erhöhbar ist. Denn durch zumindest bei Betrieb redundante Bestimmung der Umdrehungsanzahl ist eine verbesserte Sicherheit erreichbar und ein Defekt der Anordnung erkennbar. Gegebenenfalls kann der Zählwert des nicht flüchtigen Speichers durch den Wert der redundanten Bestimmung durch Überschreibung korrigiert werden.

Die Erfindung wird nun anhand von Abbildungen näher erläutert:

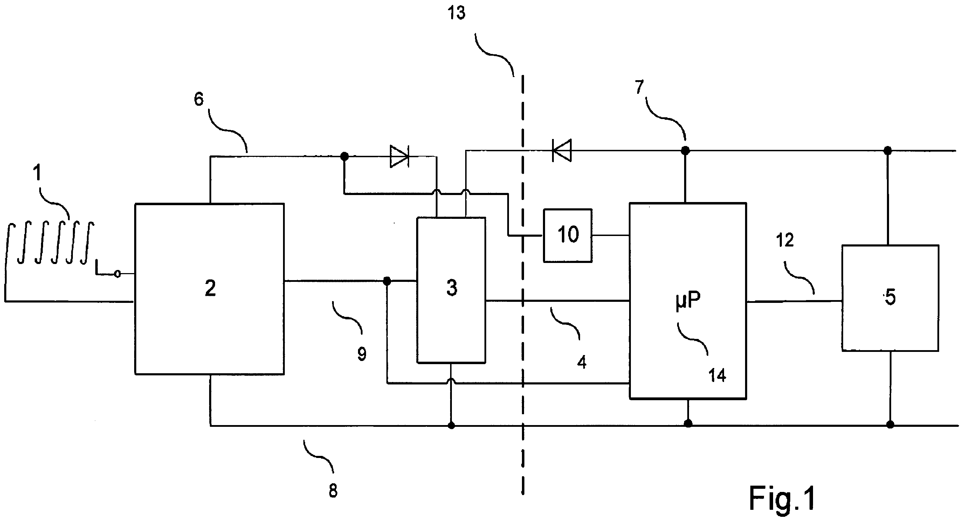

In der Figur 1 ist ein erfindungsgemäße Schaltungsanordnung schematisch dargestellt.

Bei einer Antriebskomponente, wie Getriebe, Kupplung, Bremse und/oder Elektromotor, ist am axialen Ende einer drehbar gelagerten Welle ein Dauermagnet mit der Welle verbunden, dessen Magnetisierungsrichtung in radialer Richtung ausgerichtet ist. Vorzugsweise ist der Dauermagnet an der Stirnseite des axialen Wellenendes angeordnet. Dem Dauermagneten gegenüber, also beabstandet von der Stirnseite des Wellenendes, ist eine Leiterplatte angeordnet, die einerseits zumindest einen Wieganddraht 1, also Impulsdraht, aufweist und andererseits einen Hallsensor, insbesondere einen Kreuzhallsensor. Die Leiterplatte ist mit einem Gehäuseteil fest verbunden.

Mit dem Hallsensor, der als Winkelsensor 5 ausführbar ist, ist eine Winkelbestimmung der Drehstellung der Welle ermöglicht. Allerdings ist für die Versorgung des Winkelsensors und eines Rechners 14 eine externe Versorgungsquelle notwendig. Dabei werden die Signale des Sensors 5 über die Signalleitung 12 an den Rechner 14 geführt.

Im Rechner 14 werden die Signale des Sensors 5 ausgewertet und dabei auch Rechenoperationen ausgeführt, so dass der jeweils aktuelle Winkelwert der Drehstellung der Welle bestimmbar ist.

Der Wieganddraht 1 ist derart auf der Leiterplatte angeordnet, dass die Umdrehungen der Welle detektierbar sind. Hierbei wird bei der Drehbewegung der Wieganddraht von einem ersten Pol, beispielsweise Nordpol, des Dauermagneten magnetisch vorgespannt und bei Annäherung des anderen Pols, beispielsweise Südpol, der Wieganddraht 1 ausgelöst. Hierbei erzeugt der Wieganddraht einen Impuls, also pulsartigen Spannungsverlauf. Anschließend erfolgt durch den anderen auf der drehbar gelagerten Welle angeordneten Pol, beispielsweise Südpol, eine umgekehrte Vorspannung des Drahtes. Bei Annäherung des in Umfangsrichtung gesehen nächsten umgekehrten magnetischen Pols, also beispielsweise Nordpol, wird ebenfalls ein Puls ausgelöst, der ein umgekehrtes Vorzeichen aufweist. Nach Vorspannung durch diesen magnetischen Pol wiederholt sich bei fortgesetzter Drehbewegung der Welle die beschriebene Abfolge der Pulsauslösungen. Abhängig von der Anzahl der Nord- und Südpole im System werden daher pro ganze Umdrehung der Welle minimal zwei Pulse und maximal 2^n Pulse ausgelöst, wobei n die Anzahl der Pole in Umfangsrichtung ist. Die entstandenen Pulse werden mittels eines Gleichrichters, vorzugsweise Brückengleichrichter, gleichgerichtet und auf einen Kondensator, also Energiespeicher, geführt, so dass nur Pulse einer einzigen Polarität entstehen, die Energie gespeichert wird und keine Entladung der Energie im Wiegandsensor erfolgen kann. Da der Puls genügend viel Energie enthält, um die für das Zählen der Pulse des Wieganddrahtes notwendige Energie zur Verfügung zu stellen, ist eine Fremdversorgung des entsprechend zugeordneten Teils der elektronischen Schaltung auf der Leiterplatte nicht notwendig.

Der Wieganddraht 1 ist auch als Impulsdraht bezeichenbar.

Der Puls des Wieganddrahtes 1 wird hierbei einem Signalverarbeitungsmittel 2 zugeführt, das einen Gleichrichter, einen Energiepuffer, insbesondere Kondensator, und eine Zähllogik mit Kommunikationsschnittstelle zu einem Speicher 3 aufweist.

Im Speicher 3, insbesondere im als FRAM-Speicher ausgeführten Speicher, wird die somit jeweils bestimmte Umdrehungsanzahl gespeichert.

Das vom Gleichrichter gleichgerichtete Pulssignal des Wieganddrahtes 1 wird dem Energiepuffer, also Kondensator, zugeführt. Sobald dieser nach Eintreffen eines Pulses einen kritischen Spannungswert erreicht hat, wird die Umdrehungsanzahl inkrementiert beziehungsweise dekrementiert. Zur Detektion der am Energiepuffer anliegenden Spannung wird das zugehörige Spannungssignal über ein Abtastmittel 10 zum Abtasten der Spannung 6 am Energiepuffer auch an den Rechner 14, insbesondere Mikrocontroller, geführt. Das Abtastmittel 10 ist ein Analog-Digital-Wandler, der entweder im Rechner 14 integriert angeordnet ist, so dass das Spannungssignal nur an einen A/D-Eingang, also AnalogEingang des im Rechner integriert angeordneten Analog-Digital-Wandlers, geführt werden muss, oder das Abtastmittel 10 ist ein separat zum Rechner 14 angeordneter Analog-Digital-Wandler. Innerhalb des Rechners wird somit die am Energiepuffer anliegende und in digitale Form umgewandelte Spannung auf Überschreiten eines kritischen Spannungswertes überwacht. Hierzu ist allerdings eine Versorgung des Rechners 14 aus einer externen Spannungsquelle notwendig, da die vom Wieganddraht erzeugte elektrische Pulsleistung nicht zum Betrieb des Rechners 14 ausreicht, insbesondere bei niedrigen Drehzahlen der Welle, sondern nur zur Versorgung der Zähllogik und des Speichers 3.

Außerdem ist auch eine weitergehende Auswertung des Verlaufs des vom Wieganddraht erzeugten Spannungspulses ermöglicht. Der Verlauf, also die Impulsform, wird vom Rechner 14 aufgezeichnet und ausgewertet. Insbesondere werden hierbei charakteristische Daten, wie gemittelte oder maximale Amplitude, gemittelte oder maximale Spannungsänderungsgeschwindigkeit oder Kennwerte, wie Spannungswert beim Zeitpunkt des Beschreibens des Speichers 3.

Die charakteristischen Daten der vorherig aufgetretenen Pulse werden im Speicher gespeichert und danach werden die charakteristischen Daten einer statistischen Analyse unterzogen. Insbesondere wird der zum jeweiligen charakteristischen Datum zugeordnete Mittelwert und/oder eine zugeordnete Standardabweichung oder ein anderes zugeordnetes statistisches Moment ermittelt. Die jeweils entsprechenden charakteristischen Daten des zuletzt ausgewerteten Spannungspulses werden mit diesen statistischen Werten verglichen und bei Überschreiten einer kritischen Abweichung eine Warninformation oder ein Fehlersignal ausgelöst.

Im Rechner 14 wird also ein Mittelwert der Amplituden der vorherig aufgetretenen und abgetasteten Pulse ermittelt und die Amplitude des jeweils aktuellen Pulses mit diesem Mittelwert verglichen. Wenn die zugehörige Abweichung größer ist als die Standardabweichung oder als die mit einem Faktor multiplizierte Standardabweichung, wird ein Fehlersignal ausgelöst. Andernfalls wird der aktualisierte Mittelwert bestimmt und abgespeichert. Der Faktor weist dabei einen Wert zwischen 0,5 und 3 auf.

In entsprechender Weise wird mit weiteren Kenndaten des Pulses verfahren.

Somit ist eine Auswertung jedes Pulses ermöglicht und mit den statistisch ausgewerteten Daten der vorherig aufgetretenen Pulse ausführbar.

Als Spannungsänderungsgeschwindigkeit wird ein der zeitlichen Ableitung des zeitlichen Verlaufes der Spannungswerte des Pulses entsprechender Wert verwendet. Hierzu wird die jeweilige Spannungsdifferenz zweier zeitlich aufeinander folgender Abtastwerte des Pulses bestimmt und daraus der Quotient dieser Spannungsdifferenz und des zeitlichen Abstandes der beiden Abtastwerte ermittelt. Für jeden Puls wird daraus der maximale Wert an Spannungsänderungsgeschwindigkeit bestimmt und/oder ein gemittelter Wert hiervon, der aus den ermittelten Spannungsänderungsgeschwindigkeitswerten der vorherig aufgetretenen und abgetasteten Pulse bestimmt wird.

Der Mittelwert der vorherig aufgetretenen maximalen Spannungsänderungsgeschwindigkeitswerte wird bestimmt und wiederum die Abweichung des aktuellen Spannungsänderungsgeschwindigkeitswertes zum Mittelwert bestimmt. Wenn die zugehörige Abweichung größer ist als die Standardabweichung oder als die mit einem Faktor multiplizierte Standardabweichung, wird ein Fehlersignal ausgelöst. Andernfalls wird der aktualisierte Mittelwert bestimmt und abgespeichert. Der Faktor weist dabei vorzugsweise einen Wert zwischen 0,5 und 3 auf.

Alternativ wird für die Erzeugung eines Fehlersignals der Mittelwert auf Über- bzw. Unterschreitung von fest definierten Grenzwerten geprüft.

In entsprechender Weise wird mit dem gemittelten Spannungsänderungsgeschwindigkeitswert verfahren.

Auch die beim Beschreiben des Speichers 3 vorhandene Spannung am Energiepuffer wird für jeden Puls erfasst und in entsprechender Weise die Abweichung zum Mittelwert der bisherig aufgetretenen entsprechenden Spannungen verglichen.

Außerdem ist aus den jeweils bestimmten Abweichungen zum Mittelwert eine Ausfallwahrscheinlichkeit der Anordnung bestimmbar.

Des Weiteren wird durch den Winkelsensor 5 ermöglicht, zwischen fehlerhaften Pulsen und als Kümmerling auftretenden Pulsen zu unterscheiden.

Fehlerhafte Pulse enstehen beispielsweise durch Zerstörung einer Komponente oder durch zu große Abstände zwischen dem auf der Welle angeordneten Dauermagneten und dem Wieganddraht 1. Durch solche Fehler werden Pulse ausgelöst, deren Energie und Spannungsamplitude unterhalb des ansonsten durchschnittlichen Wertes und unterhalb eines jeweils kritischen Wertes liegt. Wenn also ein solcher baulicher oder funktionsbedingter Defekt vorliegt, muss ein Fehlersignal ausgelöst werden.

Die in dieser Schrift genannten kritischen Werte sind vorgebbare Schwellwerte. Sie werden beispielsweise bei Inbetriebnahme oder schon bei Herstellung festgelegt, also in einem Speicher des Rechners 14 hinterlegt. Vorzugsweise ist der Speicher ein langzeitig die Werte abspeichernder Speicher.

Aber selbst wenn die Anordnung funktionstüchtig ist, kann ein als Kümmerling ausgebildeter Puls auftreten. Denn der Wieganddraht 1 muss vor dem Auslösen genügend magnetisch vorgespannt werden. Wenn jedoch die Welle mit dem darauf vorgesehenen Dauermagneten in demjenigen Winkelbereich einen Drehsinnwechsel vollzieht, in welchem das Auslösen erfolgt, kann es dazu kommen, dass kein vollständiges Vorspannen erreicht ist vor dem Auslösen. Solche auch als Kümmerlinge bezeichneten schwach ausgeprägten Pulse sind mit der erfindungsgemäßen Anordnung erkennbar. Denn hierzu wird die Drehbewegung mit dem Winkelsensor 5, der eine hohe Auflösung des Umdrehungswinkels ermöglicht, überwacht. Somit ist ein Drehsinnwechsel im Bereich des Auslösewinkelbereichs erkennbar und der Kümmerling somit im Rechner 14 bei der Auswertung ausschließbar.

Detektierte Impulse, bei denen vorher keine ausreichende Vorspannung festgestellt worden ist, werden von der Auswertung für die Fehlererkennung und zur Berechnung der statistischen Daten ausgeschlossen. Insbesondere wenn also kein Drehsinnwechsel vorliegt und trotzdem ein zu schwach ausgeprägter Puls vorhanden ist, wird auf einen Defekt oder Fehler der Anordnung geschlossen und daher vom Rechner 14 ein Fehlersignal ausgelöst.

Wichtig ist bei der Erfindung, dass ein Winkelsensor 5 nicht nur verwendet wird, um den Drehwinkel der Welle fein aufgelöst bestimmbar zu machen, sondern auch verwendet wird, um die vom Wieganddraht 1 erzeugten Pulse zu überwachen.

Aus den Signalen des Winkelsensors 5 ist nicht nur die Winkelstellung, also die Drehwinkelstellung der Welle, bestimmbar sondern auch die zurückgelegte Anzahl von Umdrehungen. Allerdings ist die Zählung der Umdrehungen mit dem Winkelsensor 5 nur so lange ausführbar, solange dieser und die auswertende Rechner 14 mit Energie versorgt sind. Bei Ausfall der Versorgungsspannung ist keine Bestimmung der Umdrehungsanzahl ausführbar. Hingegen ist mit dem Wieganddraht 1 und dem Speicher 3 ein energieautarkes Bestimmen der Umdrehungsanzahl ermöglicht. Bei oder nach Einschalten der Spannungsversorgung des Winkelsensors 5 übernimmt der Rechner 14 den aktuellen im Speicher 3 erfassten Umdrehungsanzahlwert als Anfangswert.

Durch ständigen Vergleich der jeweils aktuellen, vom autarken System und vom Winkelsensor 5 bestimmten Umdrehungsanzahlen ist eine Überwachung auf auftretende Fehler ermöglicht und somit die Sicherheit insgesamt erhöhbar. Außerdem kann auch eine gegenseitige Korrektur der Umdrehungsanzahlen ausgeführt werden, wenn der jeweils fehlerhafte Wert erkennbar ist.

In der Figur 1 ist die Signalleitung 4 der Kommunikationsschnittstelle zwischen dem Rechner 14 und dem Speicher 3 angeordnet.

Über die Signalleitung 6 ist die Spannung am Energiepuffer direkt abgreifbar.

Die externe Versorgungsspannung weist ein oberes Potential 7 und ein unteres Potential 8 auf. Die Signalleitung 9 verbindet das Signalverarbeitungsmittel 2, insbesondere die Zähllogik des Signalverarbeitungsmittels 2, mit dem Speicher 3.

Die Signalleitung 12 zur Übertragung der Winkelsensorsignale an den Rechner 14 verbindet den Winkelsensor 5 mit dem Rechner 14.

Die symbolisch angedeutete Trennlinie 13 trennt zwischen eigenversorgtem, also energieautarkem, und fremdversorgtem Teil der Schaltungsanordnung.

Der Rechner 14 ist vorzugsweise als Mikroprozessor oder Mikrocontroller ausgeführt, der einen Analogeingang aufweist, insbesondere mit integriertem Analog-Digital-Wandler.

Das Abtastmittel 10 ist eingangsseitig hochohmig ausgeführt, also zum Energiepuffer hin hochohmig. Somit wird der Energiepuffer nur vernachlässigbar belastet durch das Abtastmittel 10.

Der Speicher 3 ist langzeitstabil ausgeführt. Dies bedeutet, dass die gespeicherten Werte auch ohne Spannungsversorgung länger als eine Woche im Speicher erhalten bleiben. Vorzugsweise wird der Speicher in FRAM-Technik ausgeführt. Somit bleiben die Umdrehungsanzahlwerte langfristig erhalten, auch wenn keine Versorgungsspannung auftritt und auch der Wieganddraht keine Pulse erzeugt und somit auch keine Energie dem Energiepuffer zuführt.

Die Welle mit dem auf ihr drehfest verbundenen Dauermagnet ist drehbar gelagert gegen die restliche erfindungsgemäße Anordnung, also Sensor 5, Rechner 14 Abtastmittel 10, Wieganddraht 1 und Speicher 3. Vorzugsweise sind diese Komponenten auf einer Leiterplatte angeordnet, die mit einem Anlagenteil fest verbunden ist, gegen den die Welle drehbar gelagert ist.

Bei weiteren erfindungsgemäßen Ausführungsbeispielen ist das Abtastmittel 10 mit einem Impedanzwandler und/oder mit einem Komparator und/oder mit einer Verstärkerschaltung ausgebildet, insbesondere zusätzlich zum oder anstatt als Analog-Digital-Wandler. Dabei löst das Abtastmittel 10 einen Triggerpuls aus, wenn eine Mindestspannung am Energiepuffer erreicht ist. Dieser Triggerpuls wird dem Rechner 14 zugeführt, der nach Eingang des Triggerpulses beim Rechner 14 die Aufzeichnung des Spannungspulses beginnt. Mit dem Auslösen des Triggerpulses beginnt also die Aufzeichnung des Verlaufs der am Energiepuffer anliegenden Spannung. Nach Ablauf einer vorgegebenen Zeitdauer oder nach einer vorgegebenen maximalen Anzahl von Messungen, also Erfassungen der Abtastwerte des Spannungsverlaufs, oder nach Unterschreiten eines kritischen Spannungswertes wird die Aufzeichnung des Spannungspulses beendet.

Bei anderen erfindungsgemäßen Ausführungsbeispielen wird die am Energiepuffer anliegende Spannung ständig abgetastet und in einem zyklisch betriebenen Speicher abgespeichert. Der Triggerpuls für das Abspeichern der abgetasteten Werte wird dabei durch die am Energiepuffer anliegende Spannung ausgeführt. Sobald diese einen kritischen Wert überschreitet, liefert das Signalverarbeitungsmittel eine entsprechende Information, also Trigger-Information, wobei diese Information über eine Signalleitung von dem Signalverarbeitungsmittel 2 an den Rechner 14 übertragen wird, insbesondere in Form eines Datenbus- und/oder Feldbus-Kommunikationsprotokolls. Nach Eintreffen der Trigger-Information werden die im zyklischen Speicher abgelegten Abtastwerte ausgewertet. Auf diese Weise ist auch schon der anfängliche Spannungsverlauf des durch den Wieganddraht ausgewerteten Pulses ermöglicht. Dabei sind sogar Abtastwerte auswertbar, die schon vor dem Eintreffen der Trigger-Information aufgezeichnet wurden. Insbesondere ist die Anfangssteilheit, also die anfängliche Spannungsänderungsgeschwindigkeit auswertbar. Außerdem ist die Spannung beim Beschreiben des permanenten Speichers 3 besonders wichtig, da hierbei sehr viel elektrische Leistung und somit auch insgesamt Energie notwendig ist. Da der Zeitpunkt des Schreibbefehls zum Auslösen des Triggers führt, ist hierbei eine sehr genaue Messung der kritischen Spannungswerte ausführbar.

Bei weiteren erfindungsgemäßen Ausführungsbeispielen ist statt des Wieganddrahtes 1 ein anderer Mikrogenerator einsetzbar.

Bei weiteren erfindungsgemäßen Ausführungsbeispielen ist der Winkelsensor 5 nicht als Hallsensor sondern als anderer mit der Welle verbundener Winkelsensor ausgeführt, beispielsweise als induktiv arbeitender Resolver oder als mit codierter Scheibe und optischem Wirkprinzip arbeitender Inkrementalgeber. Dem Rechner 14 werden dann die Signale des Winkelsensors zugeführt oder der Rechner 14 tauscht Daten mit einem übergeordneten Rechner aus, der wiederum zum Datenaustausch verbunden ist mit dem Winkelsensor.

### Bezugszeichenliste

1 Wieganddraht, Impulsdraht und/oder Mikrogenerator
2 Signalverarbeitungsmittel
3 Speicher für Umdrehungsanzahl
4 Kommunikationsschnittstelle
5 Winkelsensor, insbesondere umfassend einen Hallsensor
6 Spannung am Energiepuffer
7 Potential der externen Versorgungsspannung
8 Masse, unteres Potential der externen Versorgungsspannung
9 Signalleitung zwischen Zähllogik des Signalverarbeitungsmittel 2 und Speicher 3
10 Abtastmittel zum Abtasten der Spannung 6 am Energiepuffer
12 Signalleitung zur Übertragung der Winkelsensorsignale an den Rechner 14
13 Trennlinie zwischen eigenversorgtem und fremdversorgtem Teil der Schaltungsanordnung
14 Rechner, insbesondere Mikroprozessor

Signal zur Auslösung eines Zählvorganges am Zähler mit nicht flüchtigem Speicher

## Patentansprüche

1. Verfahren zur Bestimmung einer Umdrehungsanzahl einer drehbar gelagerten Welle,
wobei ein Dauermagnet mit der Welle drehfest verbunden ist,
wobei die von einem mit dem Dauermagnet in Wirkverbindung angeordneten Mikrogenerator erzeugte Signalspannung einem Energiepuffer, insbesondere über einen Gleichrichter einem Kondensator, zugeführt wird,
wobei ein Speicher (3), in welchem die jeweils aktuell bestimmten Umdrehungsanzahlwerte gespeichert werden, aus dem Energiepuffer versorgt wird,
wobei die Signalspannung des Mikrogenerators (1) einer aus dem Energiepuffer versorgten Zähllogik zugeführt wird, die mit dem Speicher (3) verbunden ist zum Auslesen des jeweils alten Umdrehungsanzahlwertes und zur Abspeicherung des jeweils neu bestimmten Umdrehungsanzahlwertes,
wobei der Speicher (3) langzeitstabil ist, insbesondere in FRAM-Technik ausgeführt ist,
wobei der Dauermagnet im empfindlichen Bereich des Mikrogenerators angeordnet ist,
wobei mit einem Winkelsensor (5) der Drehwinkel der Welle bestimmt wird und einem Rechner (14) zugeführt wird,
wobei vom Rechner (14) die am Energiepuffer anliegende Spannung ausgewertet wird, wobei der vom Winkelsensor (5) detektierte Drehwinkel berücksichtigt wird,
wobei aus dem am Energiepuffer auftretenden pulsartigen Spannungsverlauf ein Wert einer Kenngröße, also Zustandsgröße, des pulsartigen Spannungsverlaufs ermittelt wird und
- entweder
der aktuelle Spannungspuls nicht zum Bestimmen der Umdrehungsanzahl verwendet wird, wenn in einem zum Spannungspuls zugehörigen Winkelabschnitt und Zeitabschnitt eine Drehsinnänderung der Welle vom Winkelsensor detektiert wird und wenn ein kritisches vorgegebenes Maß an Abweichung des Wertes von einem Mittelwert, überschritten wird,
- oder ansonsten
ein Fehlersignal ausgelöst wird, wenn das kritische vorgegebene Maß an Abweichung des Wertes von einem Mittelwert überschritten wird,
wobei der Mittelwert aus den zeitlich vorher ermittelten, entsprechenden Werten der Kenngröße bestimmt ist,
wobei das Maß von einer statistischen Größe abhängt, also von einer Standardabweichung, von einem höheren Moment einer Verteilungsfunktion,
wobei nur Pulse ausgewertet werden und zur Bestimmung der Umdrehungsanzahl verwendet werden, bei denen vorher eine ausreichende Vorspannung festgestellt worden ist durch Auswertung des Verlaufes, also Beobachtung, des Winkelwertes des fein auflösenden Winkelsensors (5).

2. Verfahren nach Anspruch 1,
**dadurch gekennzeichnet, dass**
aus dem am Energiepuffer auftretenden Spannungsverlauf ein Wert einer Kenngröße, also Zustandsgröße, des Spannungsverlaufs ermittelt wird und ein Fehlersignal ausgelöst wird bei Überschreiten eines kritischen vorgegebenen, Maßes an Abweichung des Wertes von einem Mittelwert,
wobei der Mittelwert aus den zeitlich vorher ermittelten, entsprechenden Werten der Kenngröße bestimmt ist,
wobei das Maß von einer statistischen Größe abhängt, also von einer Standardabweichung, von einem höheren Moment einer Verteilungsfunktion oder dergleichen.

3. Verfahren nach Anspruch 1 oder 2,
**dadurch gekennzeichnet, dass**
- für jeden pulsförmigen Spannungsverlauf aus dem am Energiepuffer auftretenden Spannungsverlauf ein Wert einer Kenngröße, also Zustandsgröße, des Spannungsverlaufs ermittelt wird,
- und ein Fehlersignal ausgelöst wird bei Unter- oder Überschreiten eines jeweiligen vorgegebenen Wertes, also kritischen Wertes.

4. Verfahren nach einem der vorangegangenen Ansprüche,
**dadurch gekennzeichnet, dass**
- für jeden pulsförmigen Spannungsverlauf aus dem am Energiepuffer auftretenden Spannungsverlauf ein Wert einer Kenngröße, also Zustandsgröße, des Spannungsverlaufs ermittelt wird,
- der Mittelwert dieser Kenngröße für alle Pulse bestimmt wird oder eine andere statistische Größe, wie Standardabweichung oder ein höheres Verteilungsmoment,
- und wobei ein Fehlersignal ausgelöst wird, wenn der Mittelwert beziehungsweise der Wert der anderen statistischen Größe einen vorgegebenen jeweiligen Wert, also kritischen Wert, über- oder unterschreitet.

5. Verfahren nach einem der vorangegangenen Ansprüche,
**dadurch gekennzeichnet, dass**
die Kenngröße
- eine Amplitude,
- eine maximale Spannungsänderungsgeschwindigkeit oder
- eine maximale Spannungs-Zeit-Fläche
eines der pulsförmigen Spannungsverläufe ist
oder dass die Kenngröße
- eine gemittelte Amplitude,
- eine gemittelte Spannungsänderungsgeschwindigkeit ist,
- oder eine gemittelte Spannungs-Zeit-Fläche ist
eines der pulsförmigen Spannungsverläufe ist.

6. Verfahren nach einem der vorangegangenen Ansprüche,
**dadurch gekennzeichnet, dass**
zum jeweiligen Ermitteln des Wertes der Kenngröße des pulsartigen Spannungsverlaufs ein durch einen Trigger-Puls gekennzeichneter Zeitabschnitt des pulsartigen Spannungsverlaufs ausgewertet wird vom Rechner.

7. Verfahren nach einem der vorangegangenen Ansprüche,
**dadurch gekennzeichnet, dass**
die in digitale Werte gewandelten Abtastwerte des pulsförmigen Spannungsverlaufs einem zyklisch betriebenem Speicher zugeführt werden und die Auswertung des pulsförmigen Spannungsverlaufs durch Auswertung der im zyklischen Speicher abgespeicherten Werte erfolgt nach jeweiligem Eintreffen des Trigger-Pulses.

8. Verfahren nach einem der vorangegangenen Ansprüche,
**dadurch gekennzeichnet, dass**
der Trigger-Puls durch das Überschreiten eines kritischen Wertes durch den pulsförmigen Spannungsverlauf erzeugt wird.

9. Verfahren nach einem der vorangegangenen Ansprüche,
**dadurch gekennzeichnet, dass**
zu Beginn der Inbetriebnahme oder zu Beginn des elektrischen Versorgens des Rechners die aktuelle Umdrehungsanzahl aus dem Speicher (3) zur Speicherung der Umdrehungszahl ausgelesen und vom Rechner als anfänglicher Wert für Umdrehungsanzahl verwendet wird,
wobei aus dem mittels des Winkelsensors bestimmten Verlaufs der Winkelstellung die nach dem Beginn durchlaufene Umdrehungsanzahl bestimmt wird und die Summe aus dieser Umdrehungsanzahl und dem anfänglichen Wert als jeweils aktuelle Umdrehungsanzahl im Rechner gespeichert wird.

10. Anordnung zur Bestimmung einer Umdrehungsanzahl einer drehbar gelagerten Welle, die folgende Bestandteile umfaßt :
einen Dauermagnet, der mit der drehbar gelagerten Welle drehfest verbindbar ist,
einen mit dem Dauermagnet in Wirkverbindung angeordneten Mikrogenerator (1), wobei der Dauermagnet im empfindlichen Bereich des Mikrogenerators (1) angeordnet ist,
einen Kondensator, der als Energiepuffer (2) wirkt, dem die von dem Mikrogenerator (1) erzeugte Signalspannung zugeführt wird,
einen Speicher (3) zur Speicherung der Umdrehungszahl, der aus dem Energiepuffer (2) versorgt ist, wobei der Speicher langzeitstabil ist, insbesondere in FRAM-Technik ausgeführt ist,
eine aus dem Energiepuffer (2) versorgte Zähllogik, die mit dem Speicher (3) verbunden ist, und der die Signalspannung des Mikrogenerators (1) zugeführt wird,
einen Winkelsensor (5) zur Bestimmung der Drehstellung des Drehwinkels der Welle,
einen Rechner (14), der die am Energiepuffer (2) anliegende Spannung auswertet, wobei
der Winkelsensor (5) mittels einer Signalleitung mit dem Rechner (14) verbunden ist,
wobei der Rechner (14) ein Mittel zur Auswertung der am Energiepuffer anliegenden Spannung,
also einen Analog-Digital-Wandler, aufweist oder mit einem solchen Mittel verbunden ist über eine Datenaustauschverbindung,
wobei aus dem am Energiepuffer auftretenden pulsartigen Spannungsverlauf ein Wert einer Kenngröße, also Zustandsgröße, des pulsartigen Spannungsverlaufs ermittelt wird und
entweder der aktuelle Spannungspuls nicht zum Bestimmen der Umdrehungsanzahl verwendet wird, wenn in einem zum Spannungspuls zugehörigen Winkelabschnitt und Zeitabschnitt eine Drehsinnänderung der Welle vom Winkelsensor detektiert wird und wenn ein kritisches vorgegebenes Maß an Abweichung des Wertes von einem Mittelwert, überschritten wird,
oder ansonsten ein Fehlersignal ausgelöst wird, wenn das kritische vorgegebene Maß an Abweichung des Wertes von einem Mittelwert überschritten wird,
wobei der Mittelwert aus den zeitlich vorher ermittelten, entsprechenden Werten der Kenngröße bestimmt ist,
wobei das Maß von einer statistischen Größe abhängt, also von einer Standardabweichung, von einem höheren Moment einer Verteilungsfunktion,
wobei nur Pulse ausgewertet werden und zur Bestimmung der Umdrehungsanzahl verwendet werden, bei denen vorher eine ausreichende Vorspannung festgestellt worden ist durch Auswertung des Verlaufes, also Beobachtung, des Winkelwertes des fein auflösenden Winkelsensors (5).

11. Anordnung nach Anspruch 10,
**dadurch gekennzeichnet, dass**
der Mikrogenerator als Wieganddraht ausgeführt ist oder einen Wieganddraht umfasst.

12. Anordnung nach Anspruch 10,
**dadurch gekennzeichnet, dass**
der Mikrogenerator als Impulsdraht ausgeführt ist.

13. Anordnung nach Anspruch 10, 11 oder 12,
**dadurch gekennzeichnet, dass**
zwischen Rechner und Speicher eine Signalleitung zum Datenaustausch angeordnet ist.

14. Anordnung nach Anspruch 10, 11, 12 oder 13,
**dadurch gekennzeichnet, dass**
der Winkelsensor und der Rechner sind von einer Spannungsquelle versorgt, aus welcher die Zähllogik und der Energiepuffer nicht versorgt sind.

15. Anordnung nach Anspruch 10, 11, 12, 14 oder 13,
**dadurch gekennzeichnet, dass**
der Winkelsensor einen Hallsensor aufweist, der in Wirkverbindung mit dem Dauermagnet ist, oder der Winkelsensor ein mit der Welle verbundener Resolver oder ein Inkrementalgeber ist.

## Claims

1. Method for determining a number of revolutions of a rotatably mounted shaft,
wherein a permanent magnet is connected to the shaft in a rotationally fixed manner,
wherein the signal voltage generated by a microgenerator arranged in operative connection with the permanent magnet is fed to an energy buffer, in particular via a rectifier to a capacitor,
wherein a memory (3), in which the currently determined numerical values of revolutions are each stored, is supplied from the energy buffer,
wherein the signal voltage of the microgenerator (1) is fed to counting logic, which is supplied from the energy buffer and is connected to the memory (3) for reading out each old numerical value of the revolutions and for storing each newly determined numerical value of the revolutions,
wherein the memory (3) is designed for long-term stability, in particular in FRAM technology,
wherein the permanent magnet is arranged in the sensitive region of the microgenerator,
wherein the angle of rotation of the shaft is determined using an angle sensor (5) and is fed to a computer (14),
wherein the voltage applied to the energy buffer is evaluated by the computer (14), while taking the angle of rotation detected by the angle sensor (5) into account,
wherein from the pulse-like voltage characteristic occurring at the energy buffer a value of a characteristic quantity, i.e. state quantity, of the pulse-like voltage characteristic is ascertained and
- either
the current voltage pulse is not used for determining the number of revolutions when a change in the direction of rotation of the shaft is detected by the angle sensor in an angle segment and time segment associated with the voltage pulse, and when a critical predefined degree of deviation of the value from an average value is exceeded,
- or otherwise
an error signal is triggered when the critical predefined degree of deviation of the value from an average value is exceeded,
wherein the average value is determined from the corresponding values of the characteristic quantity ascertained previously in time,
wherein the degree is dependent on a statistical quantity, i.e. a standard deviation, or a higher moment of a distribution function,
wherein only pulses in which a sufficient bias voltage has been previously established are evaluated and used for determining the number of revolutions by evaluating the characteristic of, i.e. observation of, the angular value of the finely resolving angle sensor (5).

2. Method according to claim 1,
**characterised in that**
a value of a characteristic quantity, i.e. state quantity, of the voltage characteristic is ascertained from the voltage characteristic which occurs at the energy buffer, and an error signal is triggered when a critical predefined degree of deviation of the value from an average value is exceeded,
wherein the average value is determined from the corresponding values of the characteristic quantity ascertained previously in time,
wherein the degree is dependent on a statistical quantity, i.e. on a standard deviation, of a higher moment of a distribution function or the like.

3. Method according to claim 1 or 2,
**characterised in that**
- for each pulse-shaped voltage characteristic, a value of a characteristic quantity, i.e. state quantity, of the voltage characteristic is ascertained from the voltage characteristic which occurs at the energy buffer,
- and an error signal is triggered when a particular predefined value, i.e. critical value, is not attained or is exceeded.

4. Method according to one of the preceding claims,
**characterised in that**
- for each pulse-shaped voltage characteristic, a value of a characteristic quantity, i.e. state quantity, of the voltage characteristic is ascertained from the voltage characteristic which occurs at the energy buffer,
- the average value of this characteristic quantity is determined for all pulses, or another statistical quantity, such as standard deviation or a higher distribution moment,
- and wherein an error signal is triggered when the average value or the value of the other statistical quantity exceeds or does not attain a predefined particular value, i.e. critical value.

5. Method according to one of the preceding claims,
**characterised in that**
the characteristic quantity is
- an amplitude,
- a maximum voltage change rate or
- a maximum voltage-time area
of one of the pulse-shaped voltage characteristics
or **in that** the characteristic quantity is
- an averaged amplitude,
- an averaged voltage change rate,
- or an averaged voltage-time area
of one of the pulse-shaped voltage characteristics.

6. Method according to one of the preceding claims,
**characterised in that**
to ascertain in each case the value of the characteristic quantity of the pulse-like voltage characteristic, a time segment, **characterised by** a trigger pulse, of the pulse-like voltage characteristic is evaluated by the computer.

7. Method according to one of the preceding claims,
**characterised in that**
the sampling values, converted into digital values, of the pulse-shaped voltage characteristic are fed to a cyclically operated memory, and the evaluation of the pulse-shaped voltage characteristic is effected by evaluating the values stored in the cyclical memory after each arrival of the trigger pulse.

8. Method according to one of the preceding claims,
**characterised in that**
the trigger pulse is generated by the exceeding of a critical value by the pulse-shaped voltage characteristic.

9. Method according to one of the preceding claims,
**characterised in that**
the current number of revolutions is read out from the memory (3) for storing the number of revolutions at the beginning of the initial operation or at the beginning of the electrical supply of the computer, and used by the computer as the initial value for the number of revolutions,
wherein, from the characteristic of the angular position determined by means of the angle sensor, the number of revolutions performed following the beginning is determined and the sum of this number of revolutions and the initial value is stored in the computer as the respective current number of revolutions.

10. Arrangement for determining a number of revolutions of a rotatably mounted shaft, which comprises the following components:
a permanent magnet which is connectable to the rotatably mounted shaft in a rotationally fixed manner,
a microgenerator (1) arranged in operative connection with the permanent magnet, wherein the permanent magnet is arranged in the sensitive region of the microgenerator (1),
a capacitor which acts as energy buffer (2), to which is fed the signal voltage generated by the microgenerator (1),
a memory (3) for storing the number of revolutions, which is supplied from the energy buffer (2),
wherein the memory is designed for long-term stability, in particular in FRAM technology,
counting logic, which is supplied from the energy buffer (2) and is connected to the memory (3), and to which the signal voltage of the microgenerator (1) is fed,
an angle sensor (5) for determining the rotational position of the angle of rotation of the shaft,
a computer (14) which evaluates the voltage applied to the energy buffer (2), wherein the angle sensor (5) is connected to the computer (14) by means of a signal line,
wherein the computer (14) has a means for evaluating the voltage applied to the energy buffer, i.e. an analog-to-digital converter, or is connected to such a means via a data exchange connection,
wherein from the pulse-like voltage characteristic occurring at the energy buffer a value of a characteristic quantity, i.e. state quantity, of the pulse-like voltage characteristic is ascertained and
either the current voltage pulse is not used for determining the number of revolutions when a change in the direction of rotation of the shaft is detected by the angle sensor in an angle segment and time segment associated with the voltage pulse, and when a critical predefined degree of deviation of the value from an average value is exceeded,
or otherwise an error signal is triggered when the critical predefined degree of deviation of the value from an average value is exceeded,
wherein the average value is determined from the corresponding values of the characteristic quantity ascertained previously in time,
wherein the degree is dependent on a statistical quantity, i.e. a standard deviation, or a higher moment of a distribution function,
wherein only pulses in which a sufficient bias voltage has been previously established are evaluated and used for determining the number of revolutions by evaluating the characteristic of, i.e. observation of, the angular value of the finely resolving angle sensor (5).

11. Arrangement according to claim 10,
**characterised in that**
the microgenerator is designed as a Wiegand wire or comprises a Wiegand wire.

12. Arrangement according to claim 10,
**characterised in that**
the microgenerator is designed as a pulse wire.

13. Arrangement according to claim 10, 11 or 12,
**characterised in that**
a signal line for the exchange of data is arranged between the computer and the memory.

14. Arrangement according to claim 10, 11, 12 or 13,
**characterised in that**
the angle sensor and the computer are supplied by a voltage source from which the counting logic and the energy buffer are not supplied.

15. Arrangement according to claim 10, 11, 12, 14 or 13,
**characterised in that**
the angle sensor comprises a Hall-effect sensor which is in operative connection with the permanent magnet, or the angle sensor is a resolver connected to the shaft or is an incremental encoder.

## Revendications

1. Procédé pour déterminer un nombre de révolutions d'un arbre monté tournant,
dans lequel un aimant permanent est solidaire en rotation de l'arbre,
dans lequel la tension de signal générée par un microgénérateur disposé en liaison fonctionnelle avec l'aimant permanent est amenée à un réservoir d'énergie, en particulier via un redresseur à un condensateur,
dans lequel une mémoire (3) dans laquelle sont mémorisées les valeurs du nombre de révolutions actuellement déterminées, est alimentée à partir du réservoir d'énergie,
dans lequel la tension de signal du microgénérateur (1) est amenée à une logique de comptage alimentée à partir du réservoir d'énergie, qui est reliée à la mémoire (3) pour la lecture de l'ancienne valeur du nombre de révolutions et pour l'enregistrement de la valeur du nombre de révolutions nouvellement déterminée,
dans lequel la mémoire (3) est stable à long terme, en particulier réalisée en technique FRAM,
dans lequel l'aimant permanent est disposé dans la zone sensible du microgénérateur,
dans lequel l'angle de rotation de l'arbre est déterminé avec un capteur d'angle (5) et amené à un ordinateur (14),
dans lequel la tension présente au réservoir d'énergie est évaluée par l'ordinateur (14), l'angle de rotation détecté par le capteur d'angle (5) étant pris en compte,
dans lequel une valeur d'une grandeur caractéristique, c'est-à-dire d'une grandeur d'état, de la forme d'onde de tension impulsionnelle est déterminée à partir de la forme d'onde de tension impulsionnelle apparaissant au réservoir d'énergie et
- soit
l'impulsion de tension actuelle n'est pas utilisée pour déterminer le nombre de révolutions si un changement de sens de rotation de l'arbre est détecté par le capteur d'angle dans un secteur angulaire et un intervalle de temps associés à l'impulsion de tension et si un niveau critique prédéfini d'écart de la valeur par rapport à une valeur moyenne est dépassé,
- soit
un signal d'erreur est déclenché si le niveau critique prédéfini d'écart de la valeur par rapport à une valeur moyenne est dépassé,
la valeur moyenne étant déterminée à partir des valeurs correspondantes, déterminées précédemment dans le temps, de la grandeur caractéristique,
le niveau dépendant d'une grandeur statistique, c'est-à-dire d'un écart-type, d'un moment d'ordre plus élevé d'une fonction de répartition,
dans lequel seules sont évaluées et utilisées pour déterminer le nombre de révolutions les impulsions pour lesquelles une prétension suffisante a été préalablement constatée par évaluation de la forme d'onde, c'est-à-dire observation de la valeur angulaire du capteur d'angle (5) à haute résolution.

2. Procédé selon la revendication 1,
**caractérisé en ce**
**qu'**à partir de la forme d'onde de tension apparaissant au réservoir d'énergie, une valeur d'une grandeur caractéristique, c'est-à-dire d'une grandeur d'état, de la forme d'onde de tension est déterminée et un signal d'erreur est déclenché en cas de dépassement d'un niveau critique prédéfini d'écart de la valeur par rapport à une valeur moyenne,
la valeur moyenne étant déterminée à partir des valeurs correspondantes, déterminées précédemment dans le temps, de la grandeur caractéristique,
le niveau dépendant d'une grandeur statistique, c'est-à-dire d'un écart-type, d'un moment d'ordre plus élevé d'une fonction de répartition ou analogue.

3. Procédé selon la revendication 1 ou 2,
**caractérisé en ce que**
- une valeur d'une grandeur caractéristique, c'est-à-dire d'une grandeur d'état, de la forme d'onde de tension est déterminée pour chaque forme d'onde de tension impulsionnelle à partir de la forme d'onde de tension apparaissant au réservoir d'énergie,
- et un signal d'erreur est déclenché en cas de soupassement ou de dépassement d'une valeur prédéfinie, c'est-à-dire critique, respective.

4. Procédé selon l'une des revendications précédentes,
**caractérisé en ce que**
- une valeur d'une grandeur caractéristique, c'est-à-dire d'une grandeur d'état, de la forme d'onde de tension est déterminée pour chaque forme d'onde de tension impulsionnelle à partir de la forme d'onde de tension apparaissant au réservoir d'énergie,
- la valeur moyenne de cette grandeur caractéristique est déterminée pour toutes les impulsions ou une autre grandeur statistique, comme l'écart-type ou un moment de répartition d'ordre plus élevé,
- et un signal d'erreur étant déclenché si la valeur moyenne, respectivement la valeur de l'autre grandeur statistique, dépasse ou soupasse une valeur prédéfinie, c'est-à-dire critique, respective.

5. Procédé selon l'une des revendications précédentes,
**caractérisé en ce que**
la grandeur caractéristique est
- une amplitude,
- une vitesse maximale de variation de tension ou
- une surface tension-temps maximale
d'une des formes d'onde de tension impulsionnelles
ou que la grandeur caractéristique est
- une amplitude moyenne,
- une vitesse moyenne de variation de tension,
- ou une surface tension-temps moyenne
d'une des formes d'onde de tension impulsionnelles.

6. Procédé selon l'une des revendications précédentes,
**caractérisé en ce que**
pour la détermination respective de la valeur de la grandeur caractéristique de la forme d'onde de tension impulsionnelle, un intervalle de temps **caractérisé par** une impulsion de déclenchement de la forme d'onde de tension impulsionnelle est évalué par l'ordinateur.

7. Procédé selon l'une des revendications précédentes,
**caractérisé en ce que**
les échantillons, convertis en valeurs numériques, de la forme d'onde de tension impulsionnelle sont amenés à une mémoire fonctionnant cycliquement et l'évaluation de la forme d'onde de tension impulsionnelle par évaluation des valeurs mémorisées dans la mémoire cyclique a lieu après l'arrivée respective de l'impulsion de déclenchement.

8. Procédé selon l'une des revendications précédentes,
**caractérisé en ce que**
l'impulsion de déclenchement est générée par le dépassement d'une valeur critique par la forme d'onde de tension impulsionnelle.

9. Procédé selon l'une des revendications précédentes,
**caractérisé en ce**
**qu'**au début de la mise en service ou au début de l'alimentation électrique de l'ordinateur, le nombre de révolutions actuel est lu dans la mémoire (3) servant à mémoriser le nombre de révolutions et utilisé par l'ordinateur comme valeur initiale du nombre de révolutions,
le nombre de révolutions effectuées après le début étant déterminé à partir de la forme d'onde de la position angulaire déterminée au moyen du capteur d'angle et la somme de ce nombre de révolutions et de la valeur initiale étant mémorisé comme nombre de révolutions actuel dans l'ordinateur.

10. Dispositif pour déterminer un nombre de révolutions d'un arbre monté tournant, lequel comprend les éléments constitutifs suivants :
un aimant permanent qui peut être rendu solidaire en rotation de l'arbre monté tournant,
un microgénérateur (1) disposé en liaison fonctionnelle avec l'aimant permanent,
l'aimant permanent étant disposé dans la zone sensible du microgénérateur (1),
un condensateur qui agit en tant que réservoir d'énergie (2), auquel la tension de signal générée par le microgénérateur (1) est amenée,
une mémoire (3) pour mémoriser le nombre de révolutions, qui est alimentée à partir du réservoir d'énergie (2), la mémoire étant stable à long terme, en particulier réalisée en technique FRAM,
une logique de comptage alimentée à partir du réservoir d'énergie (2), qui est reliée à la mémoire (3) et à laquelle la tension de signal du microgénérateur (1) est amenée,
un capteur d'angle (5) pour déterminer la position de rotation de l'angle de rotation de l'arbre,
un ordinateur (14) qui évalue la tension présente au réservoir d'énergie (2), le capteur d'angle (5) étant relié à l'ordinateur (14) au moyen d'une ligne de signaux,
dans lequel l'ordinateur (14) présente un moyen pour évaluer la tension présente au réservoir d'énergie, c'est-à-dire un convertisseur analogique-numérique, ou est relié à un tel moyen par une liaison d'échange de données,
dans lequel une valeur d'une grandeur caractéristique, c'est-à-dire d'une grandeur d'état, de la forme d'onde de tension impulsionnelle est déterminée à partir de la forme d'onde de tension impulsionnelle apparaissant au réservoir d'énergie et
soit l'impulsion de tension actuelle n'est pas utilisée pour déterminer le nombre de révolutions si un changement de sens de rotation de l'arbre est détecté par le capteur d'angle dans un secteur angulaire et un intervalle de temps associés à l'impulsion de tension et si un niveau critique prédéfini d'écart de la valeur par rapport à une valeur moyenne est dépassé,
soit un signal d'erreur est déclenché si le niveau critique prédéfini d'écart de la valeur par rapport à une valeur moyenne est dépassé,
la valeur moyenne étant déterminée à partir des valeurs correspondantes, déterminées précédemment dans le temps, de la grandeur caractéristique,
le niveau dépendant d'une grandeur statistique, c'est-à-dire d'un écart-type, d'un moment d'ordre plus élevé d'une fonction de répartition,
dans lequel seules sont évaluées et utilisées pour déterminer le nombre de révolutions les impulsions pour lesquelles une prétension suffisante a été préalablement constatée par évaluation de la forme d'onde, c'est-à-dire observation de la valeur angulaire du capteur d'angle (5) à haute résolution.

11. Dispositif selon la revendication 10,
**caractérisé en ce que**
le microgénérateur est réalisé sous la forme d'un fil de Wiegand ou comprend un fil de Wiegand.

12. Dispositif selon la revendication 10,
**caractérisé en ce que**
le microgénérateur est réalisé sous la forme d'un fil d'impulsion.

13. Dispositif selon la revendication 10, 11 ou 12,
**caractérisé en ce**
**qu'**une ligne de signaux pour l'échange de données est disposée entre l'ordinateur et la mémoire.

14. Dispositif selon la revendication 10, 11, 12 ou 13,
**caractérisé en ce que**
le capteur d'angle et l'ordinateur sont alimentés par une source de tension à partir de laquelle la logique de comptage et le réservoir d'énergie ne sont pas alimentés.

15. Dispositif selon la revendication 10, 11, 12, 14 ou 13,
**caractérisé en ce que**
le capteur d'angle présente un capteur à effet Hall qui est en liaison fonctionnelle avec l'aimant permanent, ou le capteur d'angle est un résolveur relié à l'arbre ou un codeur incrémental.
